# EUROPÄISCHE PATENTSCHRIFT

(11) **EP 1 726 753 B1**
(45) Veröffentlichungstag und Bekanntmachung des Hinweises auf die Patenterteilung: **23.01.2008**
(21) Anmeldenummer: 06007638.7
(22) Anmeldetag: 12.04.2006
(51) Int. Cl.: E05B 65/20, H03K 17/96

(54) **Türgriff für Kraftfahrzeuge mit einem kapazitiven Näherungssensor**
Door handle for vehicle with a capacitive proximity sensor
Poignée de porte pour véhicule automobile avec un capteur de proximité capacitive

(30) Priorität: 15.04.2005 DE 102005017451
(43) Veröffentlichungstag der Anmeldung: 29.11.2006
(73) Patentinhaber: Hella KGaA Hueck & Co., 59552 Lippstadt (DE)
(72) Erfinder: Bruns, Ewald, 26409 Wittmund (DE); Siekmann, Daniel, 59556 Lippstadt (DE); Werner, Stefan, 46399 Bocholt (DE)

(56) Entgegenhaltungen:
- EP-A2- 0 954 098
- WO-A-01/40607
- WO-A-03/095776
- DE-A1- 10 051 055

## Beschreibung

Die Erfindung bezieht sich auf einen Türgriff für Kraftfahrzeuge mit einem kapazitiven Näherungssensor. Dabei dient der kapazitiven Näherungssensor zur Detektion der Annäherung einer menschlichen Hand in einem Fahrzeug-Zugangssystem, um den Entrieglungswunsch oder den Verriegelungswunsch einer Bedienperson festzustellen. Immer dann, wenn der Entriegelungs- oder Verriegelungswunsch durch Annäherung einer Hand detektiert wird, erfolgt eine Authentifikationskommunikation zwischen einem fahrzeugseitigen Steuergerät und einem vom Bediener mitgeführten ID-Geber (Funkschlüssel).

Derartige Fahrzeug-Zugangssysteme, bei denen der Entriegelungs- oder Verriegelungswunsch nicht mehr durch ein aktives Betätigen (Drücken) einer Taste an einem Funkschlüssel kundgetan wird, sondern durch Annäherung einer menschlichen Hand an den Türgriff automatisch erkannt wird, werden auch Passive Entry/Go-Systeme genannt.

Ein gattungsgemäßer Türgriff ist zum Beispiel aus der DE 100 51 055 A1 bekannt. Der Türgriff gemäß DE 100 51 055 A1 weist eine Türgriffhülle bestehend aus einer zweiteiligen Gehäuseschale auf, wobei im Inneren der Gehäuseschale zwei kapazitive Elektroden zur Annäherungsdetektion angeordnet sind. Dabei ist die 1. Elektrode mit ihrem elektrischen Feld Teil eines Entriegelungs-Näherungssensors, während die 2. Elektrode mit ihrem elektrischen Feld Teil eines Verriegelungs-Näherungssensors ist. Zur Meß/-Detektionzwecken sind die Elektroden jeweils mit einem Meß-Spannungspotential, vorzugsweise einem Wechselspannungssignal, beaufschlagbar. Zwischen diesen beiden (Meß-)Elektroden und ebenfalls innerhalb der Gehäuseschale ist eine mit dem Fahrzeugmassepotential verbundene Masseelektrode angeordnet, um die elektrischen Felder der beiden (Meß-)Elektroden gegeneinander abzuschirmen.

Zum Schutz vor Umgebungseinflüssen (Schmutz, Staub, Feuchtigkeit) und zur mechanischen Fixierung wird die mindestens eine kapazitive Elektrode des Näherungssensors oder eine die mindestens eine kapazitive Elektrode enthaltende Elektronikbaugruppe (einschließlich der Anschlussleitungen) in ein Kunststoffmaterial eingebettet. Dabei bildet das Kunststoffmaterial, in das die Elektrode bzw. die Elektronikbaugruppe eingebettet ist, zumindest in Teilbereichen auch das Dielektrikum des von der kapazitiven Elektrode erzeugten elektrischen Feldes. In der Praxis hat sich nun gezeigt, dass sich bei der Einbettung in das Kunststoffmaterial Lufteinschlüsse (Gasblasen) bilden können, die das Dielektrikum in nachteiliger Weise verändern. Durch die Lufteinschlüsse wird die Empfindlichkeit des kapazitiven Näherungssensors lokal sehr unterschiedlich, wobei es Bereiche geben kann, wo die Empfindlichkeit sehr gering ist.

Aufgabe der Erfindung ist es daher, einen Türgriff mit einem kapazitiven Näherungssensor zu schaffen, der in einem weiten Bereich eine gleichmäßig hohe Empfindlichkeit aufweist.

Diese Aufgabe wird durch die kennzeichnenden Merkmale des Patentanspruches 1 gelöst. Die sich daran anschließenden Unteransprüche enthalten vorteilhafte Ausführungsformen.

Erfindungsgemäß weist der Türgriff eine potentialfreie kapazitive Koppelfläche aus einem elektrisch leitfähigen Material auf, wobei die Koppelfläche außen auf der Türgriffhülle angeordnet sein kann der als Teil der Türgriffhülle in diese integriert sein kann.

Die Koppelfläche ist galvanisch sowohl von der kapazitiven (Meß-)Elektrode als auch vom Fahrzeugmassepotential getrennt. Die Funktion der eigentlichen kapazitiven (Meß-)Elektrode, welche mit ihren Anschlussleitungen und der zugehörigen Elektronik geschützt im Inneren des Türgriffs angeordnet ist, wird durch die kapazitive Koppelung quasi nach außen auf die Türgriffhülle übertragen. Damit wird die Empfindlichkeit des kapazitiven Näherungssensors unabhängig von Inhomogenitäten (z.B. durch Lufteinschlüsse) des Dielektrikums im Inneren des Türgriffs. Dadurch wird über einen größeren Bereich eine gleichmäßig hohe Empfindlichkeit erreicht.

Ein weiterer Vorteil der kapazitiven Koppelfläche, welche auf der Türgriffhülle angeordnet ist oder als Teil der Türgriffhülle in diese integriert ist, besteht darin, dass die Koppelfläche sich über einen größeren Bereich des Türgriffs erstrecken kann als die eigentliche kapazitive (Meß-)Elektrode. Damit kann der sensitive (empfindliche Bereich) des Näherungssensors auf Bereiche erweitert werden, die nicht direkt von der eigentlichen kapazitiven (Meß-)Elektrode abgedeckt werden. Die Größe der eigentlichen kapazitiven (Meß-)Elektrode im Inneren des Türgriffs ist aus Platzgründen aufgrund der Einbettung, der Elektronik und der Anschlussleitungen konstruktiv beschränkt.

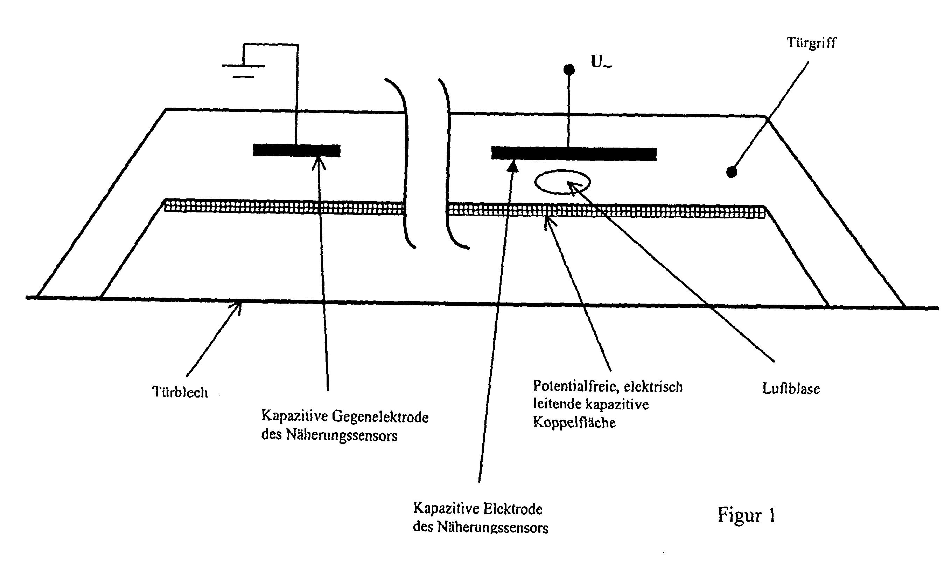

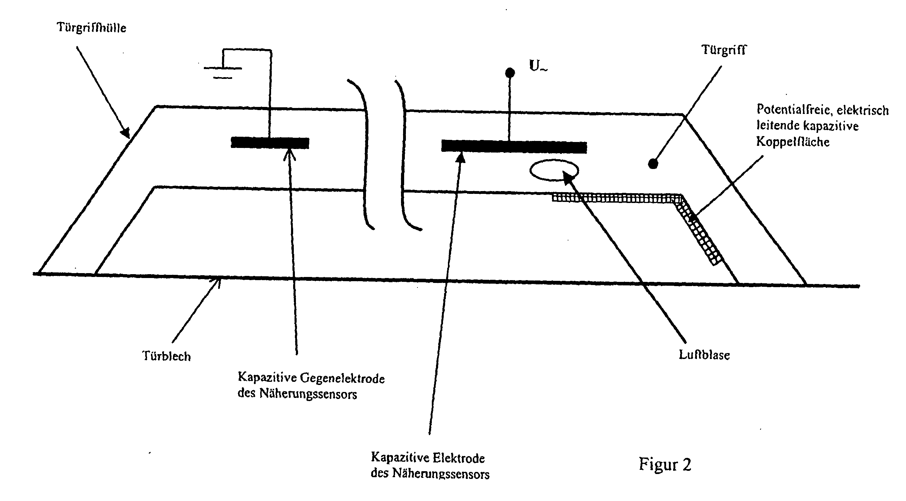

Anhand der beigefügten Zeichnung (Figur 1 und Figur 2) soll die Erfindung nachfolgend näher erläutert werden. Es ist eine schematische Darstellung eines Türgriffs gezeigt, der außenseitig auf dem Türblech einer Fahrzeugtür angeordnet ist. Der Türgriff weist als Türgriffhülle eine Gehäuseschale auf. Innerhalb der Türgriffhülle befindet sich die kapazitive (Meß-)Elektrode des Näherungssensors, die zu Messzwecken mit einem Wechselspannungssignal beaufschlagt wird, um Änderungen der Kapazität bzw. des Dielektrikums aufgrund der Anwesenheit einer menschlichen Hand zu detektieren. Innerhalb der Türgriffhülle ist eine weitere kapazitive Elektrode angeordnet, die fest mit dem Fahrzeugmassepotential verbunden ist und unter anderem als Gegenelektrode für die eigentliche (Meß-)Elektrode dient. Als Gegenelektrode kann auch das metallische Türblech dienen. Nicht dargestellt ist die Elektronikbaugruppe zur Ansteuerung und/oder Auswertung des kapazitiven Näherungssensors, welche sich ebenfalls in der Türgriffhülle befindet.

Der Türgriff weist einen länglichen Bereich auf, der im wesentlichen gerade verläuft oder zumindest wenig gekrümmt ist. Zu beiden Seiten des länglichen Bereichs erstreckt sich jeweils ein Schenkel, über den der Türgriff mit Abstand zum Türblech auf demselben befestigt ist, wobei eine Griffinulde zum Eingreifen einer Hand ausgebildet wird.

In der Ausführungsformen gemäß Figur 1 und Figur 2 ist die Koppelfläche auf der dem Türblech zugewandten Seite der Türgriffhülle angeordnet. Durch diese Anordnung der Koppelfläche wird dafür gesorgt, dass insbesondere im Bereich der Griffmulde, wo die Annäherung einer menschlichen Hand besonders zuverlässig erkannt werden muß, eine ausreichend hohe Empfindlichkeit vorhanden ist.

In der Ausführungsform gemäß Figur 1 erstreckt sich die Koppelfläche über den gesamten länglichen Bereich des Türgriffs. In der Ausführungsform gemäß Figur 2 ist die Koppelfläche nur im Übergangsbereich zwischen dem länglichen Bereich und dem Schenkel des Türgriffs angeordnet. In einem Bereich also, in dem sich die Elektrode im Inneren des Türgriffs aufgrund des dort vorhandenen Knicks oder der starken Krümmung nicht erstreckt. Ohne die Koppelfläche in diesem Bereich wäre der Näherungssensor an dieser Stelle sehr unempfindlich.

In einer nicht dargestellten Ausführungsform kann die Koppelfläche sich auch auf der dem Türblech abgewandten Seite der Türgriffhülle befinden oder sogar die gesamt Türgriffhülle umgeben. In diesem Fall bewirkt die Koppelfläche auch eine Erhöhung der Empfindlichkeit außerhalb der Griffmulde.

In den dargestellten Ausführungsformen ist die Koppelfläche auf der Türgriffhülle angeordnet. Es ist jedoch auch vorgesehen, die Koppelfläche als Teil der Türgriffhülle in diese zu integrieren, wobei auch in diesem Fall die Koppelfläche auf der Außenseite des Türgriffs als Teil seiner Hülle angeordnet wäre.

Die Koppelfläche besteht aus einem elektrisch leitfähigen Material.
In einer Ausführungsform wird hierfür Metall, vorzugsweise eine sehr dünne Metallfolie, verwendet, die auf die Türgriffhülle aufgeklebt oder aufkaschiert wird. Die Dicke der Metallfolie beträgt dabei nur wenige Zehntelmillimeter oder weniger. In einer alternativen Ausführungsform besteht die Koppelfläche aus einem elektrisch leitfähigen Lack, der auf die Türgriffhülle aufgebracht wird. Die Dicke der elektrisch leitenden Lackschicht beträgt dabei nur wenige Mikrometer. Nach der Applizierung der elektrischen leitfähigen Koppelfläche (Metallfolie oder elektrisch leitfähiger Lack) wird die Türgriffhülle mit einem dekorativen Lacküberzug versehen, von dem dann auch die Koppelfläche verdeckt wird.

In einer Ausführungsform ist die mindestens eine kapazitive Elektrode des Näherungssensors oder eine die mindestens eine kapazitive Elektrode enthaltende Elektronikbaugruppe innerhalb der Gehäuseschale in ein dielektrisches Kunststoffmaterial eingebettet. Für diese Ausführungsform gibt es zwei Herstellungsvarianten: In der ersten Variante werden die kapazitive Elektrode bzw. die Elektronikbaugruppe außerhalb der Gehäuseschale in das Kunststoffmaterial eingebettet und anschießend im eingebetteten Zustand in die Gehäuseschale eingesetzt. In der zweiten Variante werden die kapazitive Elektrode bzw. die Elektronikbaugruppe in die Gehäuseschale eingesetzt und erst im bereits eingesetzten Zustand in das Kunststoffmaterial eingebettet, indem das Kunststoffmaterial in flüssiger oder pastöser Form in die Gehäuseschale gegeben und dann aushärtet wird.

In einer alternativen Ausführungsform wird die mindestens eine kapazitive Elektrode des Näherungssensors oder eine die mindestens eine kapazitive Elektrode enthaltende Elektronikbaugruppe ebenfalls in ein dielektrisches Kunststoffmaterial eingebettet ist, wobei allerdings diese Einbettung gleichzeitig die Türgriffhülle bildet. Die erfindungsgemäße Koppelfläche wird dann auf die Einbettung appliziert oder außenseitig in diese integriert.

## Patentansprüche

1. Türgriff für Kraftfahrzeuge mit einem kapazitiven Näherungssensor zur Detektion der Annäherung einer menschlichen Hand,
- wobei der Türgriff eine Türgriffhülle aufweist,
- wobei im Inneren der Türgriffhülle eine kapazitive Elektrode des Näherungssensors angeordnet ist, die mit einem vom Massepotential des Fahrzeuges verschiedenen Spannungspotential beaufschlagbar ist,
**dadurch gekennzeichnet, dass**
- der Türgriff eine potentialfreie kapazitive Koppelfläche aus einem elektrisch leitfähigen Material aufweist,
- die Koppelfläche auf der Türgriffhülle angeordnet ist,
oder
- die Koppelfläche als Teil der Türgriffhülle in diese integriert ist.

2. Türgriff nach Anspruch 1,
**dadurch gekennzeichnet, dass**
die Koppelfläche auf der dem Türblech zugewandten Seite der Türgriffhülle angeordnet ist.

3. Türgriff nach einem der vorstehenden Ansprüche,
**dadurch gekennzeichnet, dass**
die Koppelfläche aus Metall besteht.

4. Türgriff nach Anspruch 3,
**dadurch gekennzeichnet, dass**
die Koppelfläche eine Metallfolie ist.

5. Türgriff nach einem der Ansprüche 1 bis 2,
**dadurch gekennzeichnet, dass**
die Koppelfläche aus einem elektrisch leitfähigen Lack besteht, der auf die Türgriffhülle aufgebracht wird.

6. Türgriff nach einem der vorstehenden Ansprüche,
**dadurch gekennzeichnet, dass**
im Inneren der Türgriffhülle eine weitere kapazitive Elektrode angeordnet ist, die mit dem Massepotential des Fahrzeuges verbunden ist.

7. Türgriff nach einem der vorstehenden Ansprüche,
**dadurch gekennzeichnet, dass**
die Türgriffhülle von einer Gehäuseschale gebildet wird.

8. Türgriff nach Anspruch 7,
**dadurch gekennzeichnet, dass**
die mindestens eine kapazitive Elektrode des Näherungssensors oder eine die mindestens eine kapazitive Elektrode enthaltende Elektronikbaugruppe innerhalb der Gehäuseschale in dielektrisches Kunststoffmaterial eingebettet ist.

9. Türgriff nach einem der Ansprüche 1 bis 6,
die mindestens eine kapazitive Elektrode des Näherungssensors oder eine die mindestens eine kapazitive Elektrode enthaltende Elektronikbaugruppe in ein dielektrisches Kunststoffmaterial eingebettet ist, wobei diese Einbettung gleichzeitig die Türgriffhülle bildet.

## Claims

1. Door handle for motor vehicles with a capacitive proximity sensor for the detection of the approach of a human hand,
- whereby the door handle has a door handle casing,
- whereby there is a capacitive electrode of the proximity sensor located inside the door handle casing which can have a different voltage potential applied than that of the vehicle ground potential,
wherein
- the door handle has a potential-free capacitive coupling surface made of electrically conductive material,
- the coupling surface is located on the door handle casing,
or
- the coupling surface is integrated in the door handle casing as part of this.

2. Door handle according to claim 1,
wherein
the coupling surface is located on the side of the door handle casing facing the door panel.

3. Door handle according to one of the above claims,
wherein
the coupling surface is made of metal.

4. Door handle according to claim 3,
wherein
the coupling surface is a metal film.

5. Door handle according to one of the claims 1 to 2,
wherein
the coupling surface is made of an electrically conductive coating which is applied to the door handle casing.

6. Door handle according to one of the above claims,
wherein
there is a further capacitive electrode located inside the door handle casing which is connected with the vehicle ground potential.

7. Door handle according to one of the above claims,
wherein
the door handle casing is formed by a housing shell.

8. Door handle according to claim 7,
wherein
at least one capacitive electrode of the proximity sensor or an electronic assembly containing at least one capacitive electrode within the housing shell is embedded in dielectric plastic material.

9. Door handle according to one of the claims 1 to 6,
where at least one capacitive electrode of the proximity sensor or an electronic assembly containing at least one capacitive electrode is embedded in a dielectric plastic material, whereby this embedding simultaneously forms the door handle casing.

## Revendications

1. Poignée de porte pour véhicules avec un capteur de proximité capacitif permettant de détecter le rapprochement d'une main humaine,
- la poignée de porte présentant une enveloppe de poignée de porte,
- une électrode capacitive du capteur de proximité étant disposée à l'intérieur de l'enveloppe de poignée de porte, laquelle électrode peut être alimentée avec un potentiel de tension différent du potentiel de masse du véhicule,
**caractérisée en ce que**
- la poignée de porte présente une surface de couplage capacitive sans potentiel réalisée en matériau électroconducteur,
- la surface de couplage est disposée sur l'enveloppe de poignée de porte,
ou
- la surface de couplage est intégrée dans l'enveloppe de poignée de porte et fait partie intégrante de celle-ci.

2. Poignée de porte selon la revendication 1, **caractérisée en ce que** la surface de couplage est disposée sur le côté de l'enveloppe de poignée de porte qui est tourné vers le panneau de porte.

3. Poignée de porte selon l'une quelconque des revendications précédentes, **caractérisée en ce que** la surface de couplage est en métal.

4. Poignée de porte selon la revendication 3, **caractérisée en ce que** la surface de couplage est un clinquant.

5. Poignée de porte selon l'une quelconque des revendications 1 à 2, **caractérisée en ce que** la surface de couplage est constituée par une peinture électroconductrice qui est appliquée sur l'enveloppe de poignée de porte.

6. Poignée de porte selon l'une quelconque des revendications précédentes, **caractérisée en ce qu'**une autre électrode capacitive est disposée à l'intérieur de l'enveloppe de poignée de porte, laquelle électrode est reliée au potentiel de masse du véhicule.

7. Poignée de porte selon l'une quelconque des revendications précédentes, **caractérisée en ce que** l'enveloppe de poignée de porte est formée par une coque.

8. Poignée de porte selon la revendication 7, **caractérisée en ce que** la au moins une électrode capacitive du capteur de proximité ou un module électronique comprenant la au moins une électrode capacitive est inséré(e) à l'intérieur de la coque en matière plastique diélectrique.

9. Poignée de porte selon l'une quelconque des revendications 1 à 6, **caractérisée en ce que** la au moins une électrode capacitive du capteur de proximité ou un module électronique comprenant la au moins une électrode capacitive est inséré(e) dans une matière plastique diélectrique, cette insertion formant en même temps l'enveloppe de poignée de porte.
